# EUROPEAN PATENT APPLICATION

(11) **EP 4 648 074 A1**
(43) Date of publication of application: **12.11.2025**
(21) Application number: 23935103.4
(22) Date of filing: 06.12.2023
(51) Int. Cl.: H01G 4/12

(54) **MLCC AND MANUFACTURING METHOD THEREFOR, AND CIRCUIT BOARD ASSEMBLY AND ELECTRONIC DEVICE**

(30) Priority: 26.04.2023 CN 202310479047
(71) Applicant: Honor Device Co., Ltd., Shenzhen, Guangdong 518040 (CN)
(72) Inventor: LIU, Liang, Shenzhen, Guangdong 518040 (CN); ZHANG, Lixin, Shenzhen, Guangdong 518040 (CN); HAN, Chao, Shenzhen, Guangdong 518040 (CN); HUANG, Yunchun, Shenzhen, Guangdong 518040 (CN); ZHANG, Guanghua, Shenzhen, Guangdong 518040 (CN)
(74) Representative: Thun, Clemens
(86) International application number: PCT/CN2023/136696
(87) International publication number: WO 2024/221936

(57) **Abstract**

This application provides an MLCC capacitor, a method for manufacturing an MLCC capacitor, a circuit board assembly, and an electronic device. An MLCC capacitor makes each ceramic medium layer and each inner electrode in a ceramic body perpendicular to a board surface of a circuit board, so that a deformation direction of the MLCC capacitor is parallel to the board surface of the circuit board, the MLCC capacitor does not collide with the circuit board, and a phenomenon of ""capacitive howling" does not occur. This can improve a use effect of an electronic device, and can especially improve use experience of the electronic device in a radio frequency transmission and reception process (for example, a call process). In addition, the circuit board does not deform, so that stability of the circuit board during long-term use can be ensured, and reliability and a service life of the circuit board can be improved. In addition, the MLCC capacitor is directly mounted on the circuit board, which occupies small space. This is beneficial to space layout of the circuit board, and can also ensure mounting precision of the MLCC capacitor, and improve reliability of the MLCC capacitor.

## Description

This application claims priority to Chinese Patent Application No. 202310479047.X, entitled "MLCC CAPACITOR, METHOD FOR MANUFACTURING MLCC CAPACITOR, CIRCUIT BOARD ASSEMBLY, AND ELECTRONIC DEVICE" filed with the China National Intellectual Property Administration on April 26, 2023, which is incorporated herein by reference in its entirety.

### TECHNICAL FIELD

This application relates to the field of electronic devices, and in particular, to an MLCC capacitor, a method for manufacturing an MLCC capacitor, a circuit board assembly, and an electronic device.

### BACKGROUND

A piezoelectric ceramic chip is a piezoelectric material having a piezoelectric effect, and is widely used in production and manufacture of a chip multi-layer ceramic capacitor (Multi-layer Ceramic Capacitors, MLCC). The MLCC is widely used in terminal devices such as mobile phones and tablet computers.

In a process in which a terminal device continuously receives and sends a signal, a radio frequency end of the terminal device generates a large quantity of changing voltage signals. Because of a piezoelectric effect of an MLCC, when a voltage applied to the MLCC changes, the MLCC deforms, further causing the MLCC to collide with a printed circuit board (Printed Circuit Board, PCM) that the MLCC is adhered to. When a frequency of the collision between the MLCC and the PCB is in a range audible to human ears, phenomena such as "capacitive howling" or "board vibration" that people usually mention occur, affecting a use effect of the terminal device.

### SUMMARY

This application provides an MLCC capacitor, a method for manufacturing an MLCC capacitor, a circuit board assembly, and an electronic device. A ceramic medium layer in an MLCC capacitor is vertically disposed on a circuit board, so that a phenomenon of "capacitive howling" does not occur, and a use effect of an electronic device can be improved.

According to a first aspect, this application provides an MLCC capacitor, mounted on a circuit board. The MLCC capacitor includes a ceramic body and an outer electrode, the outer electrode is disposed on an external surface of the ceramic body, and the outer electrode is for being electrically connected to the circuit board.

The ceramic body includes a plurality of ceramic medium layers and a plurality of inner electrodes, the plurality of ceramic medium layers are sequentially disposed in a stacking manner, one inner electrode is disposed between every two adjacent ceramic medium layers, and each inner electrode is connected to the outer electrode. Each ceramic medium layer and each inner electrode are perpendicular to a board surface of the circuit board.

The MLCC capacitor provided in this application makes each ceramic medium layer and each inner electrode in the ceramic body perpendicular to the board surface of the circuit board, so that a deformation direction of the MLCC capacitor is parallel to the board surface of the circuit board, the MLCC capacitor does not collide with the circuit board, and a phenomenon of ""capacitive howling" does not occur. This can improve a use effect of an electronic device, and can especially improve use experience of the electronic device in a radio frequency transmission and reception process (for example, a call process). In addition, the circuit board does not deform, so that stability of the circuit board during long-term use can be ensured, and reliability and a service life of the circuit board can be improved. In addition, the MLCC capacitor is directly mounted on the circuit board, which occupies small space. This is beneficial to space layout of the circuit board, and can also ensure mounting precision of the MLCC capacitor, and improve reliability of the MLCC capacitor.

In a possible implementation, in a first direction parallel to the board surface of the circuit board, each inner electrode is located in a middle region of a corresponding ceramic medium layer, and the outer electrode is disposed at least on a first surface of the ceramic body.

The first surface is a side surface of the ceramic body facing the circuit board.

The inner electrode is disposed in the middle region of the ceramic medium layer in the first direction. There is a spacing between the inner electrode and each of two opposite side edges of the ceramic medium layer in the first direction, the inner electrode extends to an edge that is of the ceramic medium layer and that is in a direction perpendicular to the board surface of the circuit board, and the inner electrode extends at least to a side edge of the ceramic medium layer facing the circuit board. Correspondingly, the outer electrode may be disposed at least on the first surface of the ceramic body facing the circuit board, to implement connection between the outer electrode and the circuit board.

In a possible implementation, the inner electrode includes a main body segment and a connection segment that are connected to each other, the main body segment extends in the first direction, the connection segment is inclined to the main body segment, and the connection segment extends to an outer surface of the ceramic body and is connected to the outer electrode.

The main body segment and the connection segment that are sequentially connected are disposed to form the inner electrode. The main body segment extends in the first direction parallel to the circuit board, and the main body segment mainly functions to store power. The connection segment that is inclined to the main body segment changes an extension direction of the inner electrode, so that the inner electrode may extend to the side edge of the ceramic medium layer facing the circuit board. Further, the outer electrode may be disposed on the side surface of the ceramic body facing the circuit board.

In a possible implementation, the connection segment includes a first segment and a second segment, a head end of the first segment and a head end of the second segment are both connected to the main body segment, a tail end of the first segment extends to the first surface, a tail end of the second segment extends to a second surface of the ceramic body, and both the first surface and the second surface are provided with the outer electrode.

The second surface is a side surface of the ceramic body opposite to the first surface.

The connection segment is disposed to include the first segment and the second segment that extend toward two sides of the main body segment. The first segment and the second segment respectively extend to the first surface and the second surface of the ceramic body, and both the first surface and the second surface of the ceramic body may be provided with the outer electrode. This facilitates mounting of the MLCC capacitor, and improves mounting efficiency of the MLCC capacitor.

In a possible implementation, the first segment and the second segment are both perpendicular to the main body segment.

In a possible implementation, the first segment obliquely extends to an edge of a corresponding side of the ceramic medium layer from the head end of the first segment to the tail end of the first segment.

The second segment obliquely extends to an edge of a corresponding side of the ceramic medium layer from the head end of the second segment to the tail end of the second segment.

In a possible implementation, an included angle between the first segment and the main body segment is the same as an included angle between the second segment and the main body segment.

The included angle between the first segment and the main body segment is made the same as the included angle between the second segment and the main body segment. In this way, inclining degrees of the first segment and the second segment remain consistent, a spacing between the first segments exposed on the first surface of the ceramic body and a spacing between the second segments exposed on the second surface of the ceramic body approximately remain consistent, and positions and spacings of outer electrodes on the first surface and the second surface of the ceramic body may approximately remain consistent, to facilitate mounting of the MLCC capacitor.

In a possible implementation, a head end of the connection segment is connected to the main body segment, a tail end of the connection segment extends to the first surface, and the first surface is provided with the outer electrode.

The head end of the connection segment is connected to the main body segment, so that the connection segment extends to the ceramic medium layer toward the first surface of the ceramic body, and the tail end of the connection segment extends to the side edge of the ceramic medium layer. In this way, the ceramic body only exposes alternately disposed connection segments on the first surface of the ceramic body, and only the first surface of the ceramic body may be provided with the outer electrode, and the MLCC capacitor may be positioned through the outer electrode.

In a possible implementation, the connection segment is perpendicular to the main body segment.

Alternatively, the connection segment inclines to an edge of a corresponding side of the ceramic medium layer from the head end of the connection segment to the tail end of the connection segment.

In a possible implementation, the connection segment is connected to an end of the main body segment.

The connection segment is connected to the end of the main body segment, and the alternately disposed connection segments are respectively corresponding to two ends of the main body segment, to ensure that there is a sufficient spacing between the alternately disposed connection segments. Further, this ensures that there is a sufficient spacing between the first electrode and the second electrode, and ensures reliability of isolation between the first electrode and the second electrode.

In a possible implementation, in a direction perpendicular to the board surface of the circuit board, the main body segment is located in a central region of the ceramic medium layer.

In the direction perpendicular to the board surface of the circuit board, the main body segment of the inner electrode is located in the central region of the ceramic medium layer, so that cone segments of the inner electrodes completely overlaps at two opposite sides in the direction perpendicular to the circuit board. This can enlarge an overlapping area between main body segments of adjacent inner electrodes, and enlarge a capacity of the MLCC capacitor.

In a possible implementation, in a stacking direction of the inner electrodes, the connection segment close to a first side of the ceramic body and the connection segment close to a second side of the ceramic body are alternately disposed. The first side and the second side are respectively two opposite sides of the ceramic body in the first direction.

The outer electrode includes a first electrode and a second electrode, the first electrode is connected to the connection segment close to the first side of the ceramic body, and the second electrode is connected to the connection segment close to the second side of the ceramic body.

Connection segments of the sequentially stacked inner electrodes are sequentially staggered, and in every two adjacent inner electrodes, a connection segment of one inner electrode is close to the first side of the ceramic body, and a connection segment of the other inner electrode is close to the second side of the ceramic body. In this way, the first electrode of the outer electrode is connected to each connection segment close to the first side of the ceramic body, and the second electrode of the outer electrode is connected to each connection segment close to the second side of the ceramic body, to implement a power storage function of the MLCC capacitor.

A spacing exists between the connection segment close to the first side and the connection segment close to the second side, to ensure that a sufficient spacing exists between the first electrode and the second electrode that are respectively connected to the connection segment close to the first side and the connection segment close to the second side, to ensure reliability of electrical isolation between the first electrode and the second electrode.

According to a second aspect, this application provides a method for manufacturing an MLCC capacitor, applied to manufacture the MLCC capacitor described above. The manufacturing method includes:
printing an inner electrode on a ceramic medium layer;
sequentially stacking a plurality of ceramic medium layers to form a stack;
segmenting the stack, for a cut surface to expose a plurality of inner electrodes that are staggered at intervals in a stacking direction of the ceramic medium layers, to form ceramic bodies; and
forming an outer electrode on an outer surface of the ceramic body, where the outer electrode is connected to each inner electrode.

In a possible implementation, the sequentially stacking a plurality of ceramic medium layers includes:
aligning edges of the ceramic medium layers.

The edges of the ceramic medium layers are aligned, so that corresponding inner electrodes on the ceramic medium layers are located in a same region, and the inner electrodes sequentially stacked is connected to the outer electrode through the alternately disposed connection segments. In this way, a manner of stacking the ceramic medium layers is simpler, and it is easier to align adjacent ceramic medium layers. This can improve manufacturing efficiency of the stack, and improve reliability and precision of the stack.

In a possible implementation, the inner electrode includes a main body segment and a connection segment that are connected to each other, the main body segment extends in a first direction parallel to a circuit board, and the connection segment is inclined to the main body segment.

The sequentially stacking a plurality of ceramic medium layers includes:
in a stacking direction of the ceramic medium layers, alternately disposing the connection segment close to a first side of the ceramic body and the connection segment close to a second side of the ceramic body. The first side and the second side are respectively two opposite sides of the ceramic body in the first direction.

Inner electrodes that are sequentially stacked are alternately disposed in a manner in which the connection segment is close to the first side of the ceramic body and the connection segment is close to the second side of the ceramic body, so that the connection segment close to the first side of the ceramic body is connected to a first electrode of the outer electrode, and the connection segment close to the second side of the ceramic body is connected to a second electrode of the outer electrode. In this way, two adjacent inner electrodes respectively carry the same amount of opposite charges, to implement a charge storage function of the MLCC capacitor.

In a possible implementation, the connection segment includes a first segment and a second segment, a head end of the first segment and a head end of the second segment are both connected to the main body segment, and a tail end of the first segment and a tail end of the second segment respectively extend toward two sides of the main body segment.

The sequentially stacking a plurality of ceramic medium layers includes:
rotating one of two adjacent ceramic medium layers by 180° in the stacking direction of the ceramic medium layers, and reversely stacking the one of the two adjacent ceramic medium layers and the other ceramic medium layer.

For the inner electrode whose connection segment includes the first segment and the second segment, two adjacent ceramic medium layers are stacked in a 180-degree reversely stacking manner, so that connection segments of the inner electrodes on the two adjacent ceramic medium layers are alternately disposed.

In a possible implementation, a head end of the connection segment is connected to the main body segment, and a tail end of the connection segment extends to a side of the main body segment.

The sequentially stacking a plurality of ceramic medium layers includes:
forming a first ceramic medium layer, where the connection segment on the first ceramic medium layer is close to the first side of the ceramic body;
forming a second ceramic medium layer, where the connection segment on the second ceramic medium layer is close to the second side of the ceramic body; and
alternately stacking the first ceramic layer and the second ceramic medium layer.

For an inner electrode in which a head end of a connection segment is connected to the main body segment and a tail end of the connection segment extends to a side of the main body segment, the first ceramic medium layer and the second ceramic medium layer are designed, so that a connection segment of an inner electrode on the first ceramic medium layer and a connection segment of an inner electrode on the second ceramic medium layer both extend toward a same side of the main body segment. In addition, the connection segment of the inner electrode on the first ceramic medium layer is close to the first side of the ceramic body, and the connection segment of the inner electrode on the second ceramic medium layer is close to the second side of the ceramic body. The first ceramic medium layer and the second ceramic medium layer are sequentially and alternately stacked, so that connection segments of inner electrodes printed on two adjacent ceramic medium layers are alternately disposed.

In a possible implementation, the forming an outer electrode includes:
forming a first electrode and a second electrode, where the first electrode is connected to the connection segment close to the first side of the ceramic body, and the second electrode is connected to the connection segment close to the second side of the ceramic body.

According to a third aspect, this application provides a circuit board assembly, including a circuit board and the MLCC capacitor described above.

The MLCC capacitor is mounted on the circuit board, and each ceramic medium layer and each inner electrode of the MLCC capacitor are perpendicular to a board surface of the circuit board.

The circuit board assembly provided in this application including the circuit board and the MLCC capacitor mounted on the circuit board makes each ceramic medium layer and each inner electrode in the ceramic body of the MLCC capacitor perpendicular to the board surface of the circuit board, so that a deformation direction of the MLCC capacitor is parallel to the board surface of the circuit board, the MLCC capacitor does not collide with the circuit board, and a phenomenon of ""capacitive howling" does not occur. This can improve a use effect of an electronic device, and can especially improve use experience of the electronic device in a radio frequency transmission and reception process (for example, a call process). In addition, the circuit board does not deform, so that stability of the circuit board during long-term use can be ensured, and reliability and a service life of the circuit board can be improved. In addition, the MLCC capacitor is directly mounted on the circuit board, which occupies small space. This is beneficial to space layout of the circuit board, and can also ensure mounting precision of the MLCC capacitor, and improve reliability of the MLCC capacitor.

According to a fourth aspect, this application provides an electronic device, including a housing and the circuit board assembly described above. The circuit board assembly is disposed in the housing.

The electronic device provided in this application includes the housing and the circuit board assembly disposed in the housing. The circuit board assembly includes the circuit board and the MLCC capacitor mounted on the circuit board. Each ceramic medium layer and each inner electrode in the ceramic body of the MLCC capacitor are disposed perpendicular to a board surface of the circuit board, so that a deformation direction of the MLCC capacitor is parallel to the board surface of the circuit board, the MLCC capacitor does not collide with the circuit board, and a phenomenon of ""capacitive howling" does not occur. This can improve a use effect of an electronic device, and can especially improve use experience of the electronic device in a radio frequency transmission and reception process (for example, a call process). In addition, the circuit board does not deform, so that stability of the circuit board during long-term use can be ensured, and reliability and a service life of the circuit board can be improved. In addition, the MLCC capacitor is directly mounted on the circuit board, which occupies small space. This is beneficial to space layout of the circuit board, and can also ensure mounting precision of the MLCC capacitor, and improve reliability of the MLCC capacitor.

### BRIEF DESCRIPTION OF DRAWINGS

FIG. 1 is a diagram of a structure of an electronic device according to an embodiment of this application;
FIG. 2 is an exploded view of a structure of an electronic device shown in FIG. 1;
FIG. 3 is a diagram of a structure of a circuit board assembly;
FIG. 4 is a partial cross-sectional view of a circuit board assembly in the related technology;
FIG. 5 is a diagram in which an MLCC capacitor in FIG. 4 deforms;
FIG. 6 is a partial diagram of a structure of another circuit board assembly in the related technology;
FIG. 7 is a diagram of a structure of an MLCC capacitor according to an embodiment of this application;
FIG. 8 is a perspective view in which an MLCC capacitor in FIG. 7 is mounted on a circuit board;
FIG. 9 is a layout diagram of a structure of a first ceramic body according to an embodiment of this application;
FIG. 10 is a diagram of a structure of a ceramic medium layer in FIG. 9 printed with an inner electrode;
FIG. 11 is a layout diagram of a structure of a second ceramic body according to an embodiment of this application;
FIG. 12 is a diagram of a structure of a ceramic medium layer in FIG. 11 printed with an inner electrode;
FIG. 13 is a layout diagram of a structure of a third ceramic body according to an embodiment of this application;
FIG. 14 is a diagram of a structure of a ceramic medium layer in FIG. 13 printed with an inner electrode;
FIG. 15 is a layout diagram of a structure of a fourth ceramic body according to an embodiment of this application;
FIG. 16 is a diagram of a structure of a ceramic medium layer in FIG. 15 printed with an inner electrode;
FIG. 17 is a layout diagram of a structure of a fifth ceramic body according to an embodiment of this application;
FIG. 18 is a flowchart of operations of a manufacturing method according to an embodiment of this application;
FIG. 19 and FIG. 20 are a flowchart of a process for forming a ceramic medium layer with an inner electrode according to an embodiment of this application;
FIG. 21 is a diagram of a stack of ceramic medium layers according to an embodiment of this application; and
FIG. 22 is a diagram of another stack of ceramic medium layers according to an embodiment of this application.

Description of reference numerals in the accompanying drawings:
1 - electronic device;
100 - display; 200 - housing; 300 - circuit board; 400 - battery; 500 - MLCC capacitor;
210 - middle frame; 220 - rear cover; 510 - ceramic body; 520 - outer electrode;
211 - middle plate part; 212 - frame part; 511 - ceramic medium layer; 512 - inner electrode; 521 - first electrode; 522 - second electrode;
5111 - first ceramic medium layer; 5112 - second ceramic medium layer; 5121 - main body segment; 5122 - connection segment;
51221 - first segment; 51222 - second segment;
500a - MLCC capacitor; 600a - solder paste; 700a - support;
510a - ceramic core body; 520a - outer electrode;
511a - ceramic medium film; and 512a - inner electrode.

### DESCRIPTION OF EMBODIMENTS

Terms used in implementations in this application are merely intended to explain specific embodiments of this application rather than being intended to limit this application.

An embodiment of this application provides an electronic device. The electronic device may be a consumer electronic product. For example, the electronic device includes, but is not limited to, a mobile phone, a portable android device (portable android device, PAD), a notebook computer (NoteBook Computer, NoteBook for short), an ultra-mobile personal computer (ultra-mobile personal computer, UMPC), a walkie-talkie, a netbook, a POS (Point of sales) machine, a personal digital assistant (personal digital assistant, PDA), a wearable device, a virtual reality (virtual reality, VR) device, an augmented reality (augmented reality, AR) device, and the like.

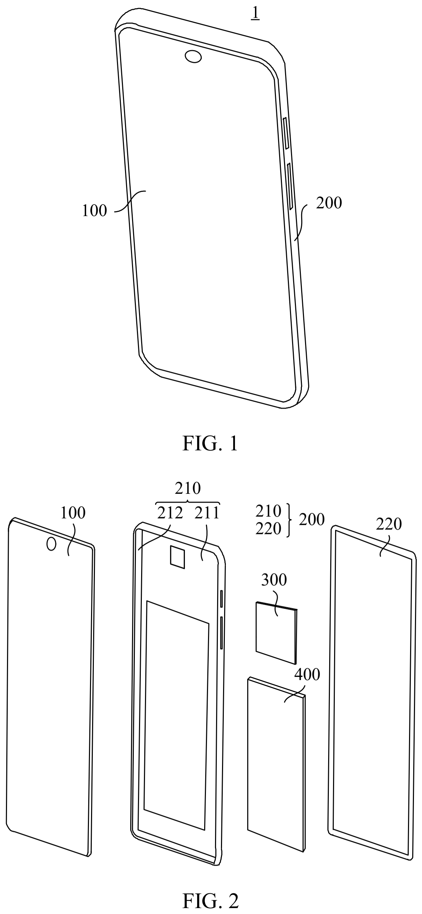

FIG. 1 is a diagram of a structure of an electronic device according to an embodiment of this application. Refer to FIG. 1. An example in which an electronic device 1 is a mobile phone is used. The electronic device 1 may include a display 100 and a housing 200. One side surface of the display 100 is configured for displaying image information. Generally, the side surface of the display 100 is defined as a front face of the display, and another side surface opposite to the front face of the display is defined as a back face of the display. The housing 200 is disposed around a peripheral side and the back face of the display 100, and is configured to support and fix the display 100 and protect the display. The front face of the display 100 is exposed out of the housing 200, for a user to view content displayed on the display 100 or perform an input operation on the electronic device 1.

Generally, a side surface on which the display 100 is located is defined as a front face of the electronic device 1, and another side surface of the electronic device 1 opposite to the front face of the electronic device is defined as a back face of the electronic device.

FIG. 2 is an exploded view of a structure of the electronic device shown in FIG. 1. Refer to FIG. 2. The housing 200 of the electronic device 1 includes a middle frame 210 and a rear cover 220. The middle frame 210 is connected between the display 100 and the rear cover 220. The display 100 is supported on a side surface of the middle frame 210, and the rear cover 220 is connected to another side surface of the middle frame 210. The display 100 is usually entirely supported on the middle frame 210, to ensure strength and stability of the display 100 and satisfy a use requirement of the display 100. The rear cover 220 is usually connected to the middle frame 210 in an overlapping manner. The middle frame 210 and the rear cover 220 jointly enclose accommodating space. The accommodating space is configured for mounting components such as a circuit board 300, a battery 400, a camera module (not shown in the figure), and a microphone (not shown in the figure).

The middle frame 210 may include a middle plate part 211 and a frame part 212. The middle plate part 211 is located between the display 100 and the rear cover 220, and is generally disposed parallel to the display 100 and the rear cover 220. The frame part 212 is disposed around a peripheral side of the middle plate part 211. For example, the frame part 212 may extend perpendicular to a board surface of the middle plate part 211 to two sides of the middle plate part 211. For example, the frame part 212 and the middle plate part 211 may be of an integrally formed structure.

The display 100 is generally mounted on the middle plate part 211 of the middle frame 210 in an integrally adhered manner. For example, the display 100 is integrally adhered to the middle plate part 211. Supporting the display 100 by the middle plate part 211 can ensure that the display 100 is supported stably and securely, so that the display 100 has sufficient strength to satisfy a use requirement that the display 100 is frequently pressed. The frame part 212 is disposed around the peripheral side of the display 100, and protects an edge of the display 100, to help the display 100 fight against risk scenarios such as a collision or falling scenario, and protect the display 100 from damage.

An edge of the rear cover 220 is connected to the frame part 212 of the middle frame 210. For example, the edge of the rear cover 220 is adhered to the frame part 212. There is a void between the middle plate part 211 of the middle frame 210 and the rear cover 220. The void forms the accommodating space described above, to mount a component in the accommodating space between the middle plate part 211 of the middle frame 210 and the rear cover 220. For example, the rear cover 220 may be approximately plate-shaped. The edge of the rear cover 220 may be overlapped to the frame part 212 of the middle frame 210, and the rear cover 220 is entirely located in a region enclosed by the frame part 212. Alternatively, the rear cover 220 is designed with a flanging bent toward the middle frame 210. The flanging is disposed around an outer side of the frame part 212 of the middle frame 210, and wraps the middle frame 210 inside the turn-up edge.

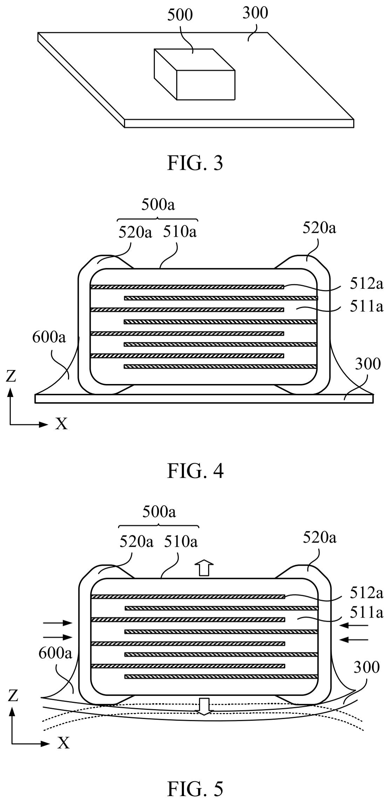

FIG. 3 is a diagram of a structure of a circuit board assembly. Refer to FIG. 3. Some components are generally disposed on a circuit board 300, and these components and the circuit board 300 jointly form a circuit board assembly. The circuit board 300 is, for example, a printed circuit board (Printed Circuit Board, PCM for short), and the components may be connected to the circuit board 300 in a manner such as soldering or plugging. A capacitor disposed on the circuit board 300 is shown in the figure. The circuit board 300 may further be provided with other components not shown in the figure. For example, the circuit board 300 may further be provided with components such as a central processing unit (Central Processing Unit, CPU), a graphics processing unit (Graphics Processing Unit, GPU), a resistor, and an inductor.

In the electronic device 1 such as a mobile phone or a tablet computer, a used capacitor usually includes a chip multi-layer ceramic capacitor (Multi-layer Ceramic Capacitors, MLCC), and the chip multi-layer ceramic capacitor is referred to as an MLCC capacitor 500 for short below.

FIG. 4 is a partial cross-sectional view of a circuit board assembly in the related technology. Refer to FIG. 4. In the related technology, an MLCC capacitor 500a includes a ceramic core body 510a and outer electrodes 520a encapsulated at two ends of the ceramic core body 510a. The outer electrodes 520a at the two ends respectively serve as a positive electrode and a negative electrode. The outer electrodes 520a at the two ends are soldered and connected to corresponding pads (not shown in the figure) on the circuit board 300 through a solder paste 600a. The ceramic core body 510a includes a plurality of ceramic medium films 511a sequentially stacked. Inner electrodes 512a are printed on the ceramic medium films 511a. Inner electrodes 512a on adjacent ceramic medium films 511a are disposed in a staggered manner. Edges of the inner electrodes 512a disposed in a staggered manner are respectively exposed on side wall surfaces on two opposite sides of the ceramic core body 510a. Outer electrodes 520a covered at the two ends of the ceramic core body 510a are respectively connected to the inner electrodes 512a on the corresponding sides.

Each of the ceramic medium films 511a in the ceramic core body 510a is stacked in a direction (a Z direction in the figure) perpendicular to the board surface of the circuit board 300. That is, the ceramic medium films 511a and the inner electrodes 512a printed on the ceramic medium films 511a are both parallel to the board surface of the circuit board 300. In a direction parallel to the board surface of the circuit board 300 (an X direction in the figure), end faces of two opposite ends of the ceramic core body 510a are respectively exposed surfaces of the staggered inner electrodes 512a. In other words, edges of the staggered inner electrodes 512a are respectively exposed on the end faces of the two ends of the ceramic core body 510a, and the outer electrodes 520a respectively cover the two opposite ends of the ceramic core body 510a and are adhered to the board surface of the circuit board 300.

During specific application, the electronic device 1 usually continuously receives and sends signals during operation, to implement a communication function of the electronic device 1. During continuous signal receiving and sending, an internal part of the electronic device 1, especially, a radio frequency end (one end at which a radio frequency antenna is located) of the electronic device 1 easily generates a large quantity of changing voltage. This affects the MLCC capacitor 500a having a piezoelectric effect.

FIG. 5 is a diagram in which the MLCC capacitor in FIG. 4 deforms. Refer to FIG. 5. When a voltage (shown by a black arrow in the figure) applied to two ends of the MLCC capacitor 500a changes, the MLCC capacitor 500a deforms in a direction (a Z direction in the figure) perpendicular to the ceramic medium film 511a. Because the ceramic medium film 511a is disposed parallel to a board surface direction (the X direction in the figure) of the circuit board 300, the MLCC capacitor 500a deforms in a direction (a direction shown by a hollow arrow in the figure) toward or away from the board surface of the circuit board 300.

Because the outer electrodes 520a wrapped at the two ends of the ceramic core body 510a has a specific thickness, a specific gap exists between the ceramic core body 510a and the circuit board 300. When the MLCC capacitor 500a deforms in the direction toward or away from the board surface of the circuit board 300, the MLCC capacitor 500a collides with the circuit board 300. As a voltage applied to the MLCC capacitor 500a changes, the MLCC capacitor 500a frequently collides with the circuit board 300, and when a collision frequency falls within a range audible to human ears, current sounds such as "drip" and "tick" of different frequencies are generated. This is a so-called "capacitive howling" phenomenon. During use of the electronic device 1, a current sound generated when the MLCC capacitor 500a frequently collides with the circuit board 300 is conducted to the human ears through the electronic device 1, affecting a use effect of the electronic device 1.

In addition, the MLCC capacitor 500a repeatedly collides with the circuit board 300, causing deformation of the circuit board 300. For example, as shown in FIG. 5, the circuit board 300 bends toward a direction away from the MLCC capacitor 500a or bends toward the MLCC capacitor 500a. During long-term use of the electronic device 1, the circuit board 300 constantly deforms. This may lead to an irreversible plastic deformation of the circuit board 300 in the long run, thereby affecting reliability and a service life of the circuit board 300.

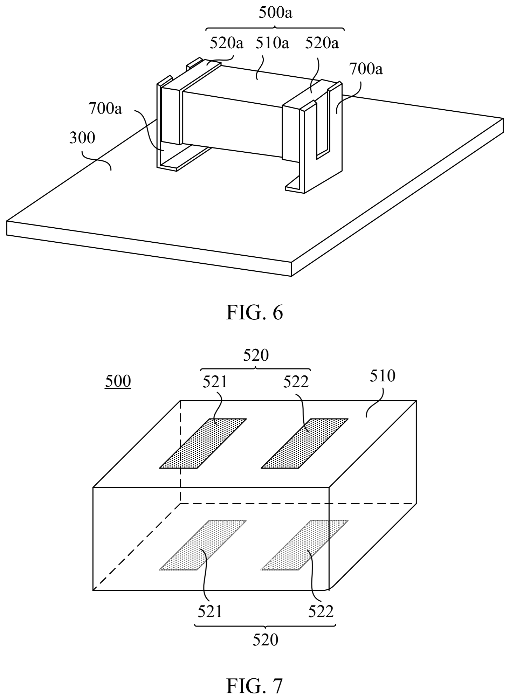

FIG. 6 is a partial diagram of a structure of another circuit board assembly in the related technology. Refer to FIG. 6. For prevent the MLCC capacitor 500a from colliding with the circuit board 300, in some other solutions in the related technology, a solution in which the MLCC capacitor 500a is mounted on the circuit board 300 is used. Supports 700a are connected to the outer electrodes 520a at the two ends of the ceramic core body 510a, and the supports 700a may be connected to the outer electrodes 520a through soldering or through connections like screws or rivets. The supports 700a extend beyond the MLCC capacitor 500a for a specific length, and are soldered to corresponding pads of the circuit board 300, to enlarge a gap between the MLCC capacitor 500a and the circuit board 300. The MLCC capacitor 500a does not contact the circuit board 300, and further, does not collide with the circuit board 300.

However, in the manner of mounting the MLCC capacitor 500a on the circuit board 300 through the supports 700a, large space is occupied, and the circuit board assembly needs more deployment space. In addition, because the supports 700a need to be processed and assembled, costs and difficulty of producing the MLCC capacitor 500a are increased, and mass production is difficult. In addition, as performance of the electronic device 1 is improved, integration of the circuit board 300 is higher, more and more densely disposed components are disposed on the circuit board 300, the supports 700a enlarge planar space occupied by the MLCC capacitor 500a, and the supports 700a are easily in contact with a peripheral component to be short-circuited. In addition, in a process of mounting the MLCC capacitor 500a, due to impact of location precision of the brackets 700a at the two ends and the manner of soldering the brackets 700a and the circuit board 300, a "tombstone phenomenon" of imbalance of mounting of the MLCC capacitor 500a is likely to occur. As a result, an inclined end of the MLCC capacitor 500a may be in contact with a shield provided on the circuit board 300, and the MLCC capacitor 500a is short-circuited.

In view of this, a disposition manner of the MLCC capacitor 500 is improved according to this embodiment of this application. Each ceramic medium layer and each inner electrode in the ceramic body of the MLCC capacitor 500 are disposed perpendicular to the board surface of the circuit board 300, so that a deformation direction of the MLCC capacitor 500 is parallel to the board surface of the circuit board 300, the MLCC capacitor 500 does not collide with the circuit board 300, and a phenomenon of ""capacitive howling" does not occur. This can improve a use effect of the electronic device 1.

A structure of the MLCC capacitor 500 in this embodiment and the manner of disposing the MLCC capacitor 500 on the circuit board 300 are described in detail below.

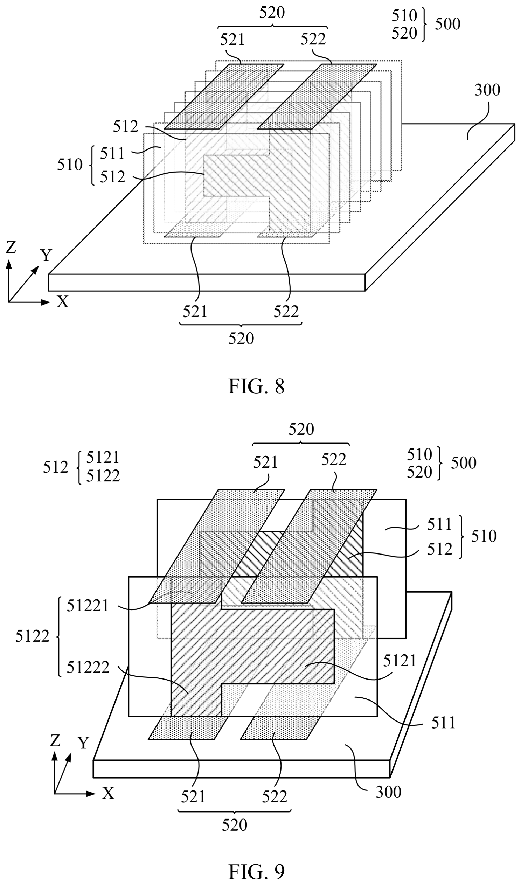

FIG. 7 is a diagram of a structure of an MLCC capacitor according to an embodiment of this application. FIG. 8 is a perspective view in which the MLCC capacitor in FIG. 7 is mounted on a circuit board.

Refer to FIG. 7. In this embodiment, the MLCC capacitor 500 includes a ceramic body 510 and an outer electrode 520. The outer electrode 520 is disposed on an external surface of the ceramic body 510. With reference to FIG. 3, the MLCC capacitor 500 is mounted on the circuit board 300, and the outer electrode 520 of the MLCC capacitor 500 is electrically connected to the circuit board 300, so that the MLCC capacitor 500 works normally.

The outer electrode 520 disposed on the outer surface of the ceramic body 510 may include a first electrode 521 and a second electrode 522. One of the first electrode 521 and the second electrode 522 is used as a positive electrode, and the other is used as a negative electrode. The first electrode 521 and the second electrode 522 are respectively soldered and connected to corresponding pads on the circuit board 300. A current loop is formed between the MLCC capacitor 500 and the circuit board 300 through the first electrode 521 and the second electrode 522, to implement a function of charging and discharging the MLCC capacitor 500.

Refer to FIG. 8. The ceramic body 510 of the MLCC capacitor includes a plurality of ceramic medium layers 511 and a plurality of inner electrodes 512, the ceramic medium layers 511 are sequentially disposed in a stacking manner, and one inner electrode 512 is disposed between every two adjacent ceramic medium layers 511. The ceramic medium layer 511 is used as an isolation layer between adjacent inner electrodes 512, and performs a function of dielectric isolation. In addition, the ceramic medium layer 511 may be used as a support layer of the inner electrode 512, and the inner electrode 512 may be printed on the ceramic medium layer 511.

In a specific application, generally, the ceramic medium layer 511 is used as a basic support structure, and the inner electrode 512 is printed on the ceramic medium layer 511. Then, the ceramic medium layers 511 printed with the inner electrodes 512 are sequentially stacked in a same direction. In other words, the ceramic medium layers 511 printed with the inner electrodes 512 are sequentially stacked in a manner that the inner electrodes 512 are located on a same side surface of the ceramic medium layers 511, to form the ceramic body 510 in which the inner electrodes 512 are sequentially disposed at an interval and the ceramic medium layers 511 are isolated between adjacent inner electrodes 512.

For protecting the inner electrodes 512, in a stacking direction of the ceramic medium layers 511, both outer wall surfaces of two opposite sides of the ceramic body 510 are usually the ceramic medium layers 511. That is, the ceramic body 510 is usually in a structural form in which an inner electrode 512 is disposed between every two adjacent ceramic medium layers 511. In view of this, when the ceramic body 510 is formed, the ceramic medium layers 511 printed with the inner electrodes 512 may be sequentially stacked, and then a single ceramic medium layer 511 (a ceramic medium layer 511 on which no inner electrode 512 is printed) is disposed on the stacked structure, so that the ceramic medium layer 511 covers the exposed inner electrodes 512.

Still refer to FIG. 8. Each inner electrode 512 in the ceramic body 510 is connected to the outer electrode 520, and each inner electrode 512 performs charge transmission with the circuit board 300 through the outer electrode 520. The circuit board 300 may deliver a charge to each inner electrode 512 through the outer electrode 520, and the charge may be stored in the ceramic body 510 through each inner electrode 512 and the ceramic medium layer 511 that is insulated and isolated between adjacent inner electrodes 512, so that the MLCC capacitor 500 implements a charging function. Each inner electrode 512 may deliver a charge to the circuit board 300 through the outer electrode 520, and the charge stored in the ceramic body 510 can be delivered to another component on the circuit board 300, so that the MLCC capacitor 500 implements a discharging function.

All the inner electrodes 512 of the ceramic body 510 are respectively connected to the first electrode 521 and the second electrode 522 in the outer electrode 520 in an alternate manner. In other words, all the inner electrodes 512 sequentially stacked are divided into two parts in an interval manner. One part of the inner electrodes 512 disposed at an interval is connected to the first electrode 521, and the other part of the inner electrodes 512 disposed at an interval is connected to the second electrode 522. In this way, in every two adjacent inner electrodes 512, one inner electrode 512 is connected to one of the first electrode 521 and the second electrode 522 that is used as a positive electrode, and the other inner electrode 512 is connected to one of the first electrode 521 and the second electrode 522 that is used as a negative electrode, so that the two adjacent inner electrodes 512 respectively carry an equal quantity of opposite charges. The ceramic medium layer 511 disposed between the two adjacent inner electrodes 512 can keep a potential difference between the two inner electrodes 512 unchanged, to implement a charge storage function of the MLCC capacitor 500.

Still refer to FIG. 8. In the MLCC capacitor 500 of this embodiment, each ceramic medium layer 511 in the ceramic body 510 is disposed perpendicular to the board surface of the circuit board 300, and correspondingly, each inner electrode 512 printed on a surface of each ceramic medium layer 511 is also perpendicular to the board surface of the circuit board 300. An example in which an XY plane shown in the figure is a plane direction of the board surface of the circuit board 300 is used, and a ZX plane shown in the figure is a plane direction of each ceramic medium layer 511 and each inner electrode 512. In this way, for the MLCC capacitor 500 that has a piezoelectric effect and whose deformation direction is perpendicular to the ceramic medium layers 511, because each ceramic medium layer 511 and each Inner electrode 512 layer of the MLCC capacitor 500 are perpendicular to the board surface of the circuit board 300, the deformation direction of the MLCC capacitor 500 is parallel to the board surface of the circuit board 300, and the MLCC capacitor 500 does not interfere with the circuit board 300.

In this way, even if the MLCC capacitor 500 is in a constantly changing electric field, so that the MLCC capacitor 500 constantly deforms in the direction perpendicular to the ceramic medium layer 511. Because the deformation direction of the MLCC capacitor 500 is parallel to the board surface of the circuit board 300, the MLCC capacitor 500 does not collide with the circuit board 300, and a phenomenon of "capacitive howling" does not occur. This can improve a use effect of the electronic device 1, and can especially improve use experience of the electronic device 1 in a radio frequency transmission and reception process (for example, a call process).

In addition, because the MLCC capacitor 500 does not collide with the circuit board 300, the circuit board 300 does not deform, so that stability of the circuit board 300 during long-term use can be ensured, and reliability and a service life of the circuit board 300 can be improved.

In addition, the MLCC capacitor 500 in this embodiment may alternatively be directly mounted on the circuit board 300. The MLCC capacitor 500 occupies small space. This is beneficial to space layout of the circuit board 300, has low processing costs and little difficulty, and can improve production efficiency of the MLCC capacitor 500. The MLCC capacitor 500 is mounted on the circuit board 300 in a direct mounting manner, to ensure that the MLCC capacitor 500 is mounted securely and stably, ensure mounting precision of the MLCC capacitor 500, and avoid a problem like a short circuit or a tombstone of the MLCC capacitor 500.

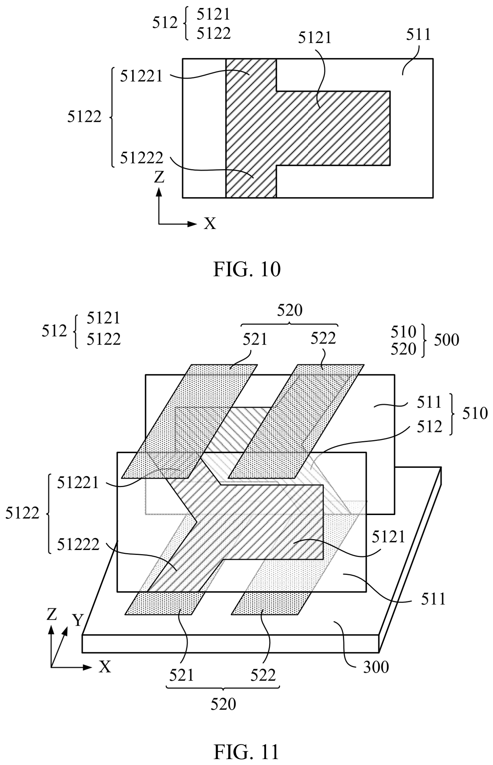

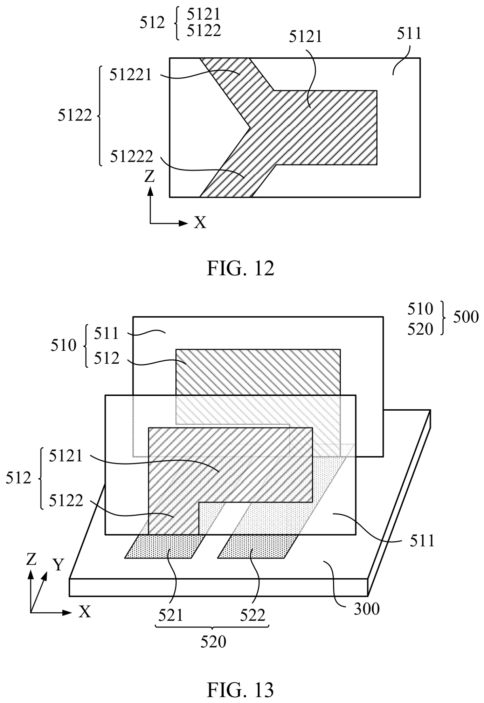

FIG. 9 is a layout diagram of a structure of a first ceramic body according to an embodiment of this application. FIG. 10 is a diagram of a structure of a ceramic medium layer in FIG. 9 printed with an inner electrode. FIG. 11 is a layout diagram of a structure of a second ceramic body according to an embodiment of this application. FIG. 12 is a diagram of a structure of a ceramic medium layer in FIG. 11 printed with an inner electrode.

Refer to FIG. 9 or FIG. 11. For ease of description, FIG. 9 and subsequent layout structure diagrams both show structures of two adjacent ceramic medium layers 511 printed with inner electrodes 512 in a ceramic body 510. In addition, in this embodiment, a direction that is in a plane direction (an XZ plane shown in the figure) of the ceramic medium layers 511 and that is parallel to the board surface of the circuit board 300 is defined as a first direction (a Y direction shown in the figure), a side surface of the ceramic body 510 facing toward the circuit board 300 is defined as a first surface of the ceramic body 510, and a side surface of the ceramic body 510 facing away from the circuit board 300 is defined as a second surface of the ceramic body 510.

In some implementations, in the first direction, an inner electrode 512 printed on each ceramic medium layer 511 may be located in a middle region of the ceramic medium layer 511. In other words, there is a spacing between the inner electrode 512 and two opposite side edges of the ceramic medium layer 511 in the first direction. The inner electrode 512 may extend toward an edge of the ceramic medium layers 511 in the direction perpendicular to the board surface of the circuit board 300 (the Z direction shown in the figure), and the inner electrode 512 extends to at least one of the two edges of the ceramic medium layers 511 in the direction. In this case, the outer electrode 520 disposed corresponding to the inner electrode 512 may be disposed on a corresponding surface of the ceramic body 510. In other words, the outer electrode 520 may be disposed on one of the first surface and the second surface of the ceramic body 510.

The outer electrode 520 should be disposed at least on the first surface of the ceramic body 510 facing the circuit board 300, so that the outer electrode 520 on the first surface may be mounted on the circuit board 300, to implement an electrical connection between the MLCC capacitor 500 and the circuit board 300. In other words, at least the first surface of the ceramic body 510 is provided with a first electrode 521 and a second electrode 522. Correspondingly, in the direction perpendicular to the board surface of the circuit board 300, the inner electrode 512 should extend at least to a side edge of the ceramic medium layer 511 facing the circuit board 300, so that the inner electrode 512 is exposed at least on the first surface of the ceramic body 510 facing the circuit board 300, for the outer electrode 520 on the first surface of the ceramic body 510 to be connected to each inner electrode 512.

Refer to FIG. 10 or FIG. 12. The inner electrode 512 located in the middle region of the ceramic medium layer 511 in the first direction may include a main body segment 5121 and a connection segment 5122. The main body segment 5121 and the connection segment 5122 are connected to each other. The main body segment 5121 may extend in the first direction (the X direction shown in the figure), and the connection segment 5122 may be inclined to the main body segment 5121, so that the connection segment 5122 may extend in a direction inclined to the first direction, for the connection segment 5122 to extend at least to the side edge of the ceramic medium layer 511 facing the circuit board 300.

The main body segment 5121 and the connection segment 5122 are disposed, so that the main body segment 5121 may occupy most of an area of the inner electrode 512, most of charges on the inner electrode 512 may be stored on the main body segment 5121, and the main body segment 5121 mainly functions to store power. The connection segment 5122 changes an extension direction of the inner electrode 512, so that the inner electrode 512 may extend to the side edge of the ceramic medium layer 511 facing the circuit board 300. Further, the outer electrode 520 may be disposed on the side surface of the ceramic body 510 facing the circuit board 300, to facilitate an electrical connection between the outer electrode 520 and the circuit board 300.

In addition, in the inner electrodes 512 sequentially stacked in the direction parallel to the board surface of the circuit board 300 (refer to FIG. 8), the connection segments 5122 of the inner electrodes 512 may be sequentially alternately staggered. In every two adjacent inner electrodes 512, a connection segment 5122 of one inner electrode 512 is close to the first side of the ceramic body 510, and a connection segment 5122 of the other inner electrode 512 is close to the second side of the ceramic body 510. The first side and the second side of the ceramic body 510 are respectively opposite sides of the ceramic body 510 in the first direction. In other words, in the stacking direction of the inner electrodes 512, the connection segment 5122 close to the first side of the ceramic body 510 and the connection segment 5122 close to the second side of the ceramic body 510 are alternately disposed.

In all the inner electrodes 512 sequentially stacked, the connection segments 5122 close to the first side of the ceramic body 510 may all be connected to the first electrode 521 in the outer electrode 520, and the connection segments 5122 close to the second side of the ceramic body 510 may all be connected to the second electrode 522 in the outer electrode 520, so that all the inner electrodes 512 are respectively connected to the first electrode 521 and the second electrode 522 in an alternate manner (refer to FIG. 8). In the first direction of the ceramic body 510, there is a particular spacing between the connection segment 5122 close to the first side of the ceramic body 510 and the connection segment 5122 close to the second side of the ceramic body 510, to provide a sufficient spacing distance between the first electrode 521 and the second electrode 522 that are respectively connected to the connection segment 5122 close to the first side of the ceramic body 510 and the connection segment 5122 close to the second side of the ceramic body 510, to prevent the first electrode 521 from being short-circuited to the second electrode 522.

The main body segments 5121 of the inner electrodes 512 are enabled to extend in the first direction, to position the inner electrodes 512, so that the inner electrodes 512 are disposed in the middle regions that are of the ceramic medium layers 511 and that are in a direction (the Z direction in the figure) perpendicular to the circuit board 300, and there are spacings between the inner electrodes 512 and two side edges of the ceramic medium layer 511 in the direction. Therefore, the first electrode 521 and the second electrode 522 are both in contact with only the connection segment 5122 of the corresponding inner electrode 512, and a region between the first electrode 521 and the second electrode 522 is occupied by the ceramic medium layer 511. This can ensure reliability of electrical isolation between the first electrode 521 and the second electrode 522.

Refer to FIG. 9 or FIG. 11. In some implementations, the connection segments 5122 of the inner electrodes 512 may extend to the first surface and the second surface of the ceramic body 510. In other words, the connection segments 5122 of the inner electrodes 512 are exposed to the first surface and the second surface of the ceramic body 510. In this way, both the first surface and the second surface of the ceramic body 510 may be provided with an outer electrode 520. In other words, both the first surface and the second surface of the ceramic body 510 may be provided with an outer electrode 520. The outer electrodes 520 on two side surfaces are respectively connected to corresponding connection segments 5122.

Specifically, refer to FIG. 10 or FIG. 12. The connection segment 5122 of the inner electrode 512 may include a first segment 51221 and a second segment 51222. Head ends of the first segment 51221 and the second segment 51222 are both connected to the main body segment 5121. A tail end of the first segment 51221 extends to the first surface of the ceramic body 510, and a tail end of the second segment 51222 extends to the second surface of the ceramic body 510. In other words, the connection segment 5122 of the inner electrode 512 extends to two sides of the main body segment 5121, two ends of the connection segment 5122 respectively extend to the first surface and the second surface of the ceramic body 510, and two end edges of the connection segment 5122 are respectively exposed on the first surface and the second surface of the ceramic body 510.

In this case, refer to FIG. 9 or FIG. 11. Alternately disposed first segments 51221 are exposed on the first surface of the ceramic body 510. In the outer electrode 520 disposed on the first surface of the ceramic body 510, the first electrode 521 is connected to a first segment 51221 close to the first side of the ceramic body 510, and the second electrode 522 is connected to a first segment 51221 close to the second side of the ceramic body 510. Alternately disposed second segments 51222 are exposed on the second surface of the ceramic body 510. In the outer electrode 520 disposed on the second surface of the ceramic body 510, the second electrode 521 is connected to a second segment 51222 close to the first side of the ceramic body 510, and the second electrode 522 is connected to a second segment 51222 close to the second side of the ceramic body 510.

Because both the first surface and the second surface of the ceramic body 510 are provided with an outer electrode 520, when the MLCC capacitor 500 is mounted, any one of two opposite side surfaces that are of the ceramic body 510 and that are provided with the outer electrode 520 faces the circuit board 300. That is, any one of the two opposite side surfaces that are of the ceramic body 510 and that are provided with the outer electrode 520 may be used as the first surface of the ceramic body 510. In this way, mounting of the MLCC capacitor 500 is facilitated, and mounting efficiency of the MLCC capacitor 500 can be improved.

Refer to FIG. 10. As an example, the first segment 51221 and the second segment 51222 of the connection segment 5122 may be both perpendicular to the main body segment 5121. In other words, the whole connection segment 5122 may be a straight line segment, the connection segment 5122 extends toward two sides of the main body segment 5121 in a manner of being perpendicular to the main body segment 5121, and an overall shape of the inner electrode 512 is similar to an inverted "T" shape.

Refer to FIG. 12. As another example, from a head end connecting the first segment 51221 to the main body segment 5121 to the tail end of the first segment 51221, the first segment 51221 may obliquely extend toward an edge of a corresponding side of the ceramic medium layer 511. Correspondingly, from a head end connecting the second segment 51222 to the main body segment 5121 to the tail end of the second segment 51222, the second segment 51222 may also obliquely extend toward an edge of a corresponding side of the ceramic medium layer 511. An overall shape of the inner electrode 512 is similar to an inverted "Y" shape. A paper direction shown in the figure is used as an example. For a connection segment 5122 close to a left side of the ceramic medium layer 511, a first segment 51221 obliquely extends toward the left side of the ceramic medium layer 511 from a head end of the first segment 51221 to a tail end of the first segment 51221, and correspondingly, a second segment 51222 is inclined to the left side of the ceramic medium layer 511 from a head end of the second segment 51222 to a tail end of the second segment 51222.

From the head end to the tail end of the first segment 51221 (the second segment 51222), the first segment 51221 (the second segment 51222) obliquely extends toward a corresponding side of the ceramic medium layer 511. In this way, for two adjacent layers of inner electrodes 512, a spacing between alternate connection segments 5122 is increased, and a spacing between the first electrode 521 and the second electrode 522 is correspondingly increased, so that performance of electrical isolation between the first electrode 521 and the second electrode 522 can be fully ensured.

An inclined degree of the first segment 51221 and an inclined degree of the second segment 51222 may be consistent. In other words, an included angle between the first segment 51221 and the main body segment 5121 is the same as an included angle between the second segment 51222 and the main body segment 5121. In this way, spacings between the first segments 51221 that are alternately disposed and exposed on the first surface of the ceramic body 510 and spacings between the second segments 51222 that are alternately disposed and exposed on the second surface of the ceramic body 510 may be approximately consistent. A spacing between the first electrode 521 and the second electrode 522 that are disposed on the first surface of the ceramic body 510 and a spacing between the first electrode 521 and the second electrode 522 that are disposed on the second surface of the ceramic body 510 may be approximately consistent. In this way, when the MLCC capacitor 500 is mounted, any one of two opposite side surfaces that are of the ceramic body 510 and that are provided with the outer electrode 520 may be used as the first surface. In other words, any one of two opposite side surfaces that are of the ceramic body 510 and that are provided with the outer electrode 520 may face the circuit board 300, to facilitate mounting of the MLCC capacitor 500. In addition, symmetry of the inner electrode 512 is better, to facilitate design and processing of the inner electrode 512.

Regardless of whether the first segment 51221 and the second segment 51222 of the connection segment 5122 are both perpendicular to the main body segment 5121, or the first segment 51221 and the second segment 51222 are inclined to corresponding sides of the ceramic medium layer 511 from the head end to the tail end, the connection segment 5122 may be connected to a middle portion of the main body segment 5121 (in a length direction) on the premise that there is a sufficient spacing between the alternately disposed connection segments 5122 and reliability of insulation and isolation between the first electrode 521 and the second electrode 522 can be ensured. Alternatively, the connection segment 5122 may be connected to an end of the main body segment 5121 (in the length direction). The alternately disposed connection segments 5122 respectively correspond to two ends of the main body segment 5121. This can ensure that there is a sufficient spacing between the alternately disposed connection segments 5122, and ensure reliability of isolation between the first electrode 521 and the second electrode 522.

In another example, on the premise that there is a sufficient spacing between the alternately disposed connection segments 5122 and reliability of insulation and isolation between the first electrode 521 and the second electrode 522 can be ensured, the first segment 51221 (the second segment 51222) may alternatively be inclined to the middle of the main body segment 5121 from the head end of the first segment 51221 (the second segment 51222) to the tail end of the first segment 51221 (the second segment 51222). This is not limited in this embodiment. In this case, the head end of the first segment 51221 and the head end of the second segment 51222 may both be connected to an end of the main body segment 5121, to reserve a sufficient spacing between the first segments 51221 (the second segments 51222) that are alternately disposed and exposed on a corresponding surface of the ceramic body 510.

For a case in which the connection segment 5122 of the inner electrode 512 includes a first segment 51221 and a second segment 51222, and the first segment 51221 and the second segment 51222 are axisymmetric with respect to the main body segment 5121, when the ceramic body 510 is formed, the same structure may be adopted for all the ceramic medium layers 511 printed with the inner electrodes 512. When the ceramic medium layers 511 are stacked, adjacent ceramic medium layers 511 may be reversely stacked by 180°, so that inner electrodes 512 on the adjacent ceramic medium layers 511 are alternately disposed.

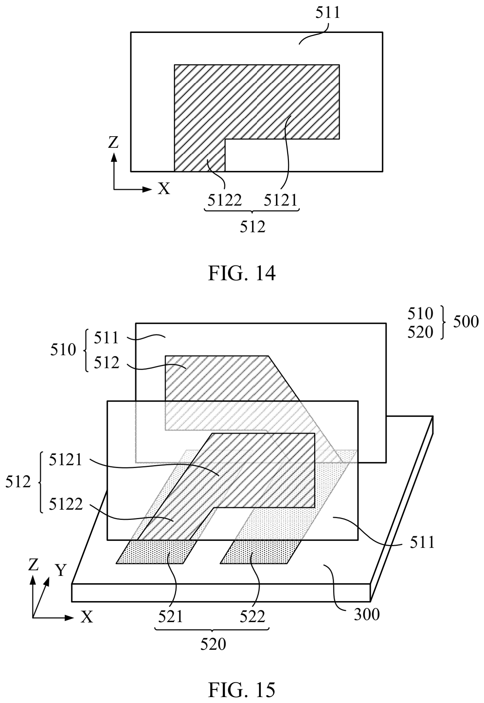

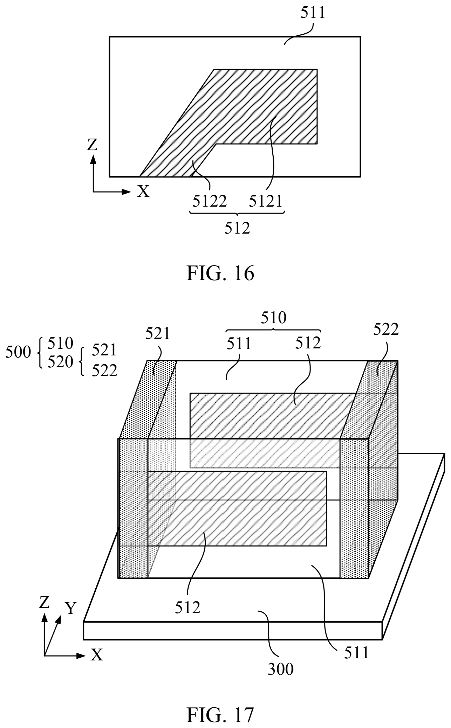

FIG. 13 is a layout diagram of a structure of a third ceramic body according to an embodiment of this application; FIG. 14 is a diagram of a structure of a ceramic medium layer in FIG. 13 printed with an inner electrode; FIG. 15 is a layout diagram of a structure of a fourth ceramic body according to an embodiment of this application; and FIG. 16 is a diagram of a structure of a ceramic medium layer in FIG. 15 printed with an inner electrode.

Refer to FIG. 13 or FIG. 15. In some other implementations, for an inner electrode 512 including a main body segment 5121 and a connection segment 5122, the connection segment 5122 of the inner electrode 512 may extend only to the first surface of the ceramic body 510. In other words, the connection segment 5122 of the inner electrode 512 is exposed only on the first surface of the ceramic body 510. In view of this, an outer electrode 520 may be disposed on only the first surface of the ceramic body 510, so that the outer electrode 520 is connected to the connection segment 5122 exposed on the first surface of the ceramic body 510.

Specifically, refer to FIG. 14 or FIG. 16. A head end of the connection segment 5122 of the inner electrode 512 may be connected to the main body segment 5121, the connection segment 5122 extends to a side of the ceramic medium layer 511 facing the first surface of the ceramic body 510, and the connection segment 5122 extends to the side edge of the ceramic medium layer 511, and is exposed on the first surface of the ceramic body 510. In this case, refer to FIG. 13 or FIG. 15. Alternately disposed connection segments 5122 are exposed on the first surface of the ceramic body 510. In the outer electrode 520 disposed on the first surface of the ceramic body 510, the first electrode 521 is connected to a connection segment 5122 close to the first side of the ceramic body 510, and the second electrode 522 is connected to a connection segment 5122 close to the second side of the ceramic body 510.

Because the outer electrode 520 is disposed on only the first surface of the ceramic body 510, when the MLCC capacitor 500 is mounted, a side surface of the ceramic body 510 on which the outer electrode 520 is disposed is used as the first surface of the ceramic body 510, so that the first surface of the ceramic body 510 faces the circuit board 300. An outer electrode 520 disposed on an external surface of the ceramic body 510 is used to position the ceramic body 510, to ensure that the MLCC capacitor 500 is correctly mounted.

Refer to FIG. 14. In an example, the connection segment 5122 of the inner electrode 512 is perpendicular to the main body segment 5121, and an overall shape of the inner electrode 512 is similar to an inverted "L" shape. Refer to FIG. 16. In another example, the connection segment 5122 may obliquely extend to an edge of a corresponding side of the ceramic medium layer 511 from a head end connecting the connection segment 5122 to the main body segment 5121 to a tail end of the connection segment 5122. A paper direction shown in the figure is used as an example. A connection segment 5122 close to the left side of the ceramic medium layer 511 is inclined to the left side of the ceramic medium layer 511 from the head end of the connection segment 5122 to the tail end of the connection segment 5122.

The connection segment 5122 obliquely extends toward the corresponding side of the ceramic medium layer 511. In this way, for two adjacent layers of inner electrodes 512, a spacing between alternate connection segments 5122 is increased, and a spacing between the first electrode 521 and the second electrode 522 is correspondingly increased, so that performance of electrical isolation between the first electrode 521 and the second electrode 522 can be fully ensured. Details are not described herein again.

Similar to the foregoing case in which the connection segment 5122 includes the first segment 51221 and the second segment 51222, for a case in which the connection segment 5122 extends to the first surface of the ceramic body 510 only to a single side of the main body segment 5121, regardless of whether the connection segment 5122 is perpendicular to the main body segment 5121, or the connection segment 5122 is inclined to the corresponding side of the ceramic medium layer 511 from the head end to the tail end, the connection segment 5122 may be connected to the middle portion (in the length direction) of the main body segment 5121, or the connection segment 5122 may be connected to an end (in the length direction) of the main body segment 5121. Details are not described herein again.

In addition, in another example, on the premise that there is a sufficient spacing between the alternately disposed connection segments 5122 and reliability of insulation and isolation between the first electrode 521 and the second electrode 522 can be ensured, a connection segment 5122 disposed on a single side of the main body segment 5121 may alternatively be inclined to the middle of the main body segment 5121. This is not limited in this embodiment. In this case, the head end of the connection segment 5122 may be connected to the end of the main body segment 5121. Details are not described herein again.

When the connection segment 5122 of the inner electrode 512 extends to a single side of the main body segment 5121, during forming of the ceramic body 510, ceramic medium layers 511 that are two structures and are printed with the inner electrodes 512 may be designed for an alternate structure that needs to be formed. Connection segments 5122 of the inner electrodes 512 in the two structures extends to a side edge that is of the ceramic medium layer 511 and that faces the first surface of the ceramic body 510. In addition, a connection segment 5122 of an inner electrode 512 in one structure is close to the first side of the ceramic medium layer 511, and a connection segment 5122 of an inner electrode 512 in the other structure is close to the second side of the ceramic medium layer 511. The ceramic medium layers 511 in the two structures are sequentially and alternately stacked.

On the basis that the inner electrode 512 includes the main body segment 5121 and the connection segment 5122 that are connected to each other, in this embodiment, in the direction perpendicular to the board surface of the circuit board 300 (the Z direction in FIG. 9, FIG. 11, FIG. 13, and FIG. 15), the main body segment 5121 of the inner electrode 512 may be a central region of the ceramic medium layer 511. In this way, regardless of whether the adjacent ceramic medium layers 511 are reversely stacked by 180°, or the ceramic medium layers 511 in the two structures are sequentially and alternately stacked, main body segments 5121 of inner electrodes 512 completely overlaps on two opposite sides in the direction perpendicular to the circuit board 300, so that an overlapping area between main body segments 5121 of the adjacent inner electrodes 512 can be increased. This further increases a capacity of the MLCC capacitor 500.

In addition, in the first direction (the X direction in FIG. 9, FIG. 11, FIG. 13, and FIG. 15) parallel to the circuit board 300, the inner electrode 512 may be located in a central region of the ceramic medium layer 511, and spacings between two ends of the inner electrode 512 in the first direction and corresponding sides of the ceramic medium layer 511 are equal. In this way, regardless of whether the adjacent ceramic medium layers 511 are reversely stacked by 180°, or the ceramic medium layers 511 in the two structures are sequentially and alternately stacked, the two opposite ends of the inner electrodes 512 in the first direction completely overlap, an overlapping area between the adjacent inner electrodes 512 can also be increased. This further increases a capacity of the MLCC capacitor 500.

In view of this, for a ceramic medium layer 511 printed with an inner electrode 512, a main body segment 5121 of the inner electrode 512 is located in a central region of the ceramic medium layer 511 only in the direction perpendicular to the board surface of the circuit board 300; or, the inner electrode 512 is located in a central region of the ceramic medium layer 511 only in the first direction parallel to the circuit board 300; or a main body segment 5121 of the inner electrode 512 is located in a central region of the ceramic medium layer 511 in the direction perpendicular to the board surface of the circuit board 300, and the inner electrode 512 is located in the central region of the ceramic medium layer 511 in the first direction parallel to the circuit board 300.

FIG. 17 is a layout diagram of a structure of a fifth ceramic body according to an embodiment of this application. Refer to FIG. 17. In another implementation, the inner electrode 512 may alternatively use a regular pattern shape. For example, an outline of the inner electrode 512 may be approximately rectangular. In a stacking direction of the inner electrodes 512, the inner electrodes 512 are disposed in a staggered manner in the first direction (the X direction in the figure). In two adjacent inner electrodes 512, one inner electrode 512 extends to an end face of one end of the ceramic body 510 in the first direction, and the other inner electrode 512 extends to an end face of the other end of the ceramic body 510 in the first direction.

In the outer electrode 520, the first electrode 521 and the second electrode 522 are respectively disposed at two ends of the ceramic body 510 in the first direction, the first electrode 521 is connected to all of inner electrodes 512 exposed on one end surface of the ceramic body 510, and the second electrode 522 is connected to all of inner electrodes 512 exposed on the other end surface of the ceramic body 510. In addition, the first electrode 521 and the second electrode 522 are respectively connected to corresponding pads (not shown in the figure) on the circuit board 300.

The paper direction shown in the figure are used as an example. In two adjacent inner electrodes 512, one inner electrode 512 extends to a left end face of the ceramic body 510, and the other inner electrode 512 extends to a right end face of the ceramic body 510. In the outer electrode 520, the first electrode 521 may be disposed at a left end of the ceramic body 510, and the second electrode 522 may be disposed at a right end of the ceramic body 510.

An embodiment of this application further provides a method for manufacturing an MLCC capacitor 500 (a manufacturing method for short below). The manufacturing method is configured for manufacturing the foregoing MLCC capacitor 500. The manufacturing method is configured for manufacturing an MLCC capacitor 500 whose inner electrode 512 includes a main body segment 5121 and a connection segment 5122 that are connected to each other. The manufacturing method is described in detail below.

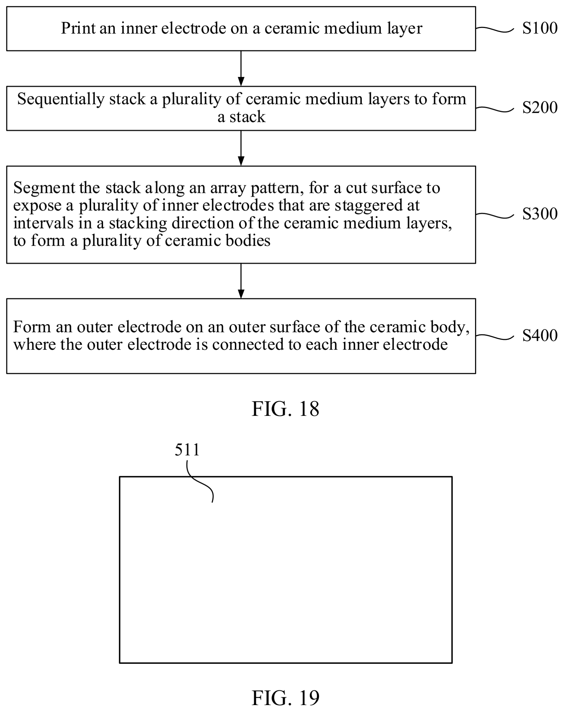

FIG. 18 is a flowchart of operations of a manufacturing method according to an embodiment of this application. Refer to FIG. 18. The manufacturing method in this embodiment may include the following operations.

S100: Print an inner electrode on a ceramic medium layer.

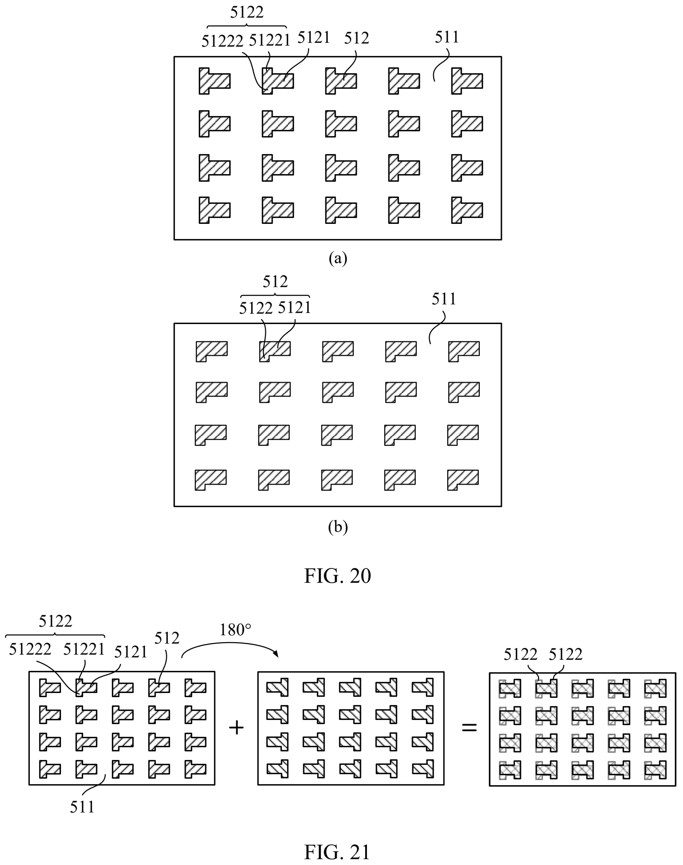

FIG. 19 and FIG. 20 are a flowchart of a process for forming a ceramic medium layer with an inner electrode according to an embodiment of this application. Refer to FIG. 19. First, a ceramic medium layer 511 is prepared. Porcelain, a ceramic powder, an adhesive, a defoamer, a solvent, and the like may be mixed together to form a ceramic slurry. Then, the ceramic slurry is cast, and then the ceramic medium layer 511 is obtained after drying. Refer to FIG. 20. Then, an inner electrode 512 is printed on the formed ceramic medium layer 511. The inner electrodes 512 may be arranged on the ceramic medium layer 511 in an array manner, to form the ceramic medium layer 511 printed with the inner electrodes 512.

For example, the inner electrode 512 may be manufactured by using a material like copper or nickel. Inner electrodes 512 arranged in an array may be printed on each ceramic medium layer 511 through screen printing. As shown in FIG. 20, an arrangement manner of the inner electrodes 512 on the ceramic medium layer 511 may be a parallel arrangement manner, and the inner electrodes 512 are arrayed on the ceramic medium layer 511 in a manner that rows and columns are completely aligned. Alternatively, the inner electrodes 512 may be arranged on the ceramic medium layer 511 in a parallel and staggered manner. For example, adjacent rows or adjacent columns of inner electrodes 512 are arranged in a staggered manner.

Regarding each inner electrode 512 printed on the ceramic medium layer 511, refer to (a) in FIG. 20. In some implementations, a connection segment 5122 of the inner electrode 512 may include a first segment 51221 and a second segment 51222. Ahead end of the first segment 51221 and a head end of the second segment 51222 are both connected to a main body segment 5121, and a tail end of the first segment 51221 and a tail end of the second segment 51222 respectively extend toward two sides of the main body segment 5121. The figure shows a form in which the connection segment 5122 is connected to an end of the main body segment 5121, and the first segment 51221 and the second segment 51222 are both perpendicular to the main body segment 5121. In another example, the connection segment 5122 may alternatively be connected to the middle of the main body segment 5121. From the head end of the first segment 51221 (the second segment 51222) to the tail end of the first segment 51221 (the second segment 51222), the first segment 51221 (the second segment 51222) may alternatively be inclined to an edge of a corresponding side of the ceramic medium layer 511, or the first segment 51221 (the second segment 51222) is inclined to the middle of the main body segment 5121. This is not limited in this embodiment.

Refer to (b) in FIG. 20. In some other implementations, a head end of the connection segment 5122 of the inner electrode 512 is connected to the main body segment 5121, and a tail end of the inner electrode 512 extends to a side of the main body segment 5121. The figure shows a form in which the connection segment 5122 is connected to an end of the main body segment 5121, and the connection segment 5122 is perpendicular to the main body segment 5121. In another example, the connection segment 5122 may alternatively be connected to the middle of the main body segment 5121. From the head end of the connection segment 5122 to a tail end of the connection segment 5122, the connection segment 5122 may alternatively be inclined to an edge of a corresponding side of the ceramic medium layer 511, or the connection segment 5122 is inclined to the middle of the main body segment 5121. This is not limited in this embodiment.

S200: Sequentially stack a plurality of ceramic medium layers to form a stack.

After the inner electrode 512 is printed on each of the ceramic medium layers 511, the ceramic medium layers 511 printed with the inner electrode 512 are sequentially stacked, to form the stack.

In this embodiment, the inner electrode 512 is connected to an outer electrode 520 through the connection segment 5122, and when the ceramic medium layers 511 are stacked, the inner electrodes 512 on the ceramic medium layers 511 are alternately disposed in a stacking direction of the ceramic medium layers 511, so that a connection segment 5122 close to a first side of a ceramic body 510 and a connection segment 5122 close to a second side of the ceramic body 510 are alternately disposed. For two adjacent ceramic medium layers 511, a connection segment 5122 of an inner electrode 512 on one of the ceramic medium layers 511 is close to the first side of the ceramic body 510, and a connection segment 5122 of an inner electrode 512 on the other ceramic medium layer 511 is close to the second side of the ceramic body 510.

In this way, in the formed stack, in a stacking direction of the inner electrodes 512, the inner electrodes 512 are alternately disposed in a manner in which the connection segments 5122 are close to the first side of the ceramic body 510 and the connection segments 5122 are close to the second side of the ceramic body 510, to facilitate subsequent connection between the inner electrodes 512 and the outer electrode 520. In the inner electrodes 512 sequentially stacked, each connection segment 5122 close to the first side of the ceramic body 510 is configured for being connected to a first electrode 521 in the outer electrode 520, and each connection segment 5122 close to the second side of the ceramic body 510 is configured for being connected to a second electrode 522 in the outer electrode 520. In this way, two adjacent inner electrodes 512 respectively carry the same amount of opposite charges, to implement a charge storage function of the MLCC capacitor 500.

In addition, because a connection segment 5122 is inclined to a main body segment 5121 extending in a first direction, when the ceramic medium layers 511 are stacked, it is unnecessary to staggeringly stacking adjacent ceramic medium layers 511, but edges of the ceramic medium layers 511 may be aligned, and corresponding inner electrodes 512 on the ceramic medium layers 511 are located in a same region. The inner electrodes 512 on the stacked ceramic medium layers 511 are connected to corresponding outer electrodes 520 through alternately disposed connection segments 5122.

In comparison with a conventional manner of sequentially staggeringly stacking the ceramic medium layers 511, in this embodiment, two adjacent ceramic medium layers 511 may be aligned, and all the ceramic medium layers 511 are sequentially aligned to form a stack. In this way, a manner of stacking the ceramic medium layers 511 is simpler, and alignment between the adjacent ceramic medium layers 511 is easier to be implemented. This can improve efficiency of manufacturing the stack, and improve reliability and precision of the stack.

FIG. 21 is a diagram of a stack of ceramic medium layers according to an embodiment of this application. Refer to FIG. 21. For the manner in which the connection segment 5122 of the inner electrode 512 includes the first segment 51221 and the second segment 51222, the head end of the first segment 51221 and the head end of the second segment 51222 are both connected to the main body segment 5121, and the tail end of the first segment 51221 and the tail end of the second segment 51222 respectively extend toward the two sides of the main body segment 5121 (refer to (a) in FIG. 20), the ceramic medium layer 511 in only one structure form may be designed, that is, the ceramic medium layers 511 printed with the inner electrode 512 are in a same structure form.

When the ceramic medium layers 511 are stacked, for two adjacent ceramic medium layers 511, after a lower layer of the ceramic medium layers 511 is disposed, an upper layer of the ceramic medium layers 511 is rotated by 180° and is stacked on the lower layer of the ceramic medium layers 511, so that connection segments 5122 of inner electrodes 512 printed on the two adjacent ceramic medium layers 511 are alternately disposed.

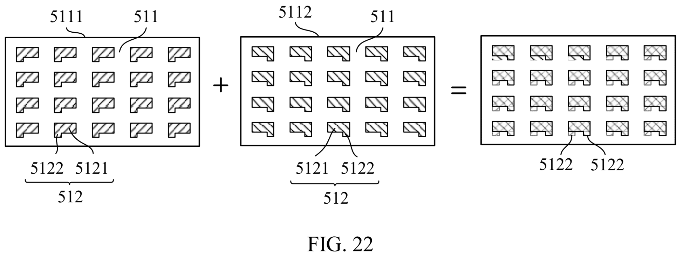

FIG. 22 is a diagram of another stack of ceramic medium layers according to an embodiment of this application. Refer to FIG. 22. For a manner in which the head end of the connection segment 5122 of the inner electrode 512 is connected to the main body segment 5121 and the tail end of the connection segment 5122 extends toward a side of the main body segment 5121 (refer to (b) in FIG. 20), two structure forms of ceramic medium layers 511 may be designed. In this embodiment, the two types of ceramic medium layers 511 are respectively defined as a first ceramic medium layer 5111 and a second ceramic medium layer 5112. A connection segment 5122 of an inner electrode 512 on the first ceramic medium layer 5111 and a connection segment 5122 of an inner electrode 512 on the second ceramic medium layer 5112 both extend toward a same side of the main body segment 5121. In addition, the connection segment 5122 of the inner electrode 512 on the first ceramic medium layer 5111 is close to the first side of the ceramic body 510, and the connection segment 5122 of the inner electrode 512 on the second ceramic medium layer 5112 is close to the second side of the ceramic body 510.

When the ceramic medium layers 511 are stacked, the first ceramic medium layers 5111 and the second ceramic medium layers 5112 are sequentially and alternately stacked, and two adjacent ceramic medium layers 511 are aligned, so that connection segments 5122 of inner electrodes 512 printed on the two adjacent ceramic medium layers 511 are alternately disposed.

S300: Segment the stack, for a cut surface to expose a plurality of inner electrodes that are staggered at intervals in the stacking direction of the ceramic medium layers, to form a plurality of ceramic bodies.

After the stack is formed by sequentially stacking the ceramic medium layers 511 printed with the inner electrode 512, the stack may be subsequently laminated, so that the ceramic medium layers 511 in the stack are more closely combined, to improve reliability of the stack, and facilitate subsequent cutting of the stack.

For example, the stack may be loaded into a laminating bag, the laminating bag is evacuated, and pressing is performed in an isostatic pressing manner, to perform lamination on the stack. In this way, the inner electrode 512 is not deformed due to a pressing force of the lamination, so that a thickness of each of the ceramic medium layers 511 can be reduced. Therefore, it is easier to manufacture an MLCC capacitor 500 having a small size and a large capacity, and quality of the MLCC capacitor 500 can be sufficiently ensured.

After the stack is laminated, the stack is cut in the stacking direction of the ceramic medium layers 511 along an array pattern of the inner electrodes 512 arranged in an array on the ceramic medium layers 511, to form a plurality of ceramic bodies 510. Each ceramic medium layer 511 of each ceramic body 510 includes one inner electrode 512.

After the stack is cut in the stacking direction of the ceramic medium layers 511, a plurality of inner electrodes 512 that are staggered at intervals are exposed on a cut surface of connection segments 5122 corresponding to the inner electrodes 512. In other words, in each of the formed ceramic bodies 510, a plurality of inner electrodes 512 that are staggered at intervals are exposed on a side wall surface of the ceramic body 510. Each connection segment 5122 close to the first side of the ceramic body 510 is configured for being connected to a subsequently formed first electrode 521, and each connection segment 5122 close to the second side of the ceramic body 510 is configured for being connected to a subsequently formed second electrode 522.

S400: Form an outer electrode 520 on an outer surface of the ceramic body 510, where the outer electrode 520 is connected to each inner electrode 512.

After each of the ceramic bodies 510 is formed through cutting, next, an outer electrode 520 needs to be formed on an outer surface of the ceramic body 510. The formed outer electrode 520 includes a first electrode 521 and a second electrode 522. The first electrode 521 is connected to each of the connection segments 5122 close to the first side of the ceramic body 510, and the second electrode 522 is connected to each of the connection segments 5122 close to the second side of the ceramic body 510.

A series of processing operations are usually further included before the outer electrode 520 is formed on the outer surface of the ceramic body 510. For example, processing operations of performing debinding, sintering, and chamfering on the ceramic body 510 are further included before the outer electrode 520 is formed.

Debinding is to perform high-temperature baking on the ceramic body 510 based on a specific temperature curve (a maximum temperature is generally around 400°C), to remove an organic material like an adhesive from the ceramic body 510, so as to avoid delamination and cracking of the ceramic body 510 due to rapid volatilization of the organic material in a subsequent process. Sintering is to perform high-temperature processing on the ceramic body 510 after debinding is completed, and a sintering temperature is generally between 1100 °C and 1400 °C. Chamfering is to put the sintered ceramic body 510 and a friction medium into a chamfering tank, and make the ceramic body 510 form a smooth surface based on friction methods such as ball milling and planetary grinding, to ensure that inner electrodes 512 on a surface of the ceramic body 510 are fully exposed and a connection between the inner electrode 512 and the outer electrode 520 is reliable.

In the descriptions of embodiments of this application, unless otherwise explicitly specified and defined, the terms such as "mount", "connect", and "connection" should be understood in a broad sense. For example, the connection may be a fixed connection, an indirect connection through an intermediary, internal communication between two components, or an interaction relationship between two components. A person of ordinary skill in the art may understand the specific meanings of the foregoing terms in embodiments of this application according to specific situations.

The terms such as "first", "second", "third", and "fourth" (if any) in the specification and claims of embodiments of this application and in the accompanying drawings are used for distinguishing similar objects and not necessarily used for describing any particular order or sequence.

## Claims

1. An MLCC capacitor mounted on a circuit board, wherein the MLCC capacitor comprises a ceramic body and an outer electrode, the outer electrode is disposed on an external surface of the ceramic body, and the outer electrode is for being electrically connected to the circuit board; and
the ceramic body comprises a plurality of ceramic medium layers and a plurality of inner electrodes, the plurality of ceramic medium layers are sequentially disposed in a stacking manner, one inner electrode is disposed between every two adjacent ceramic medium layers, and each inner electrode is connected to the outer electrode, wherein each ceramic medium layer and each inner electrode are perpendicular to a board surface of the circuit board.

2. The MLCC capacitor according to claim 1, wherein in a first direction parallel to the board surface of the circuit board, each inner electrode is located in a middle region of a corresponding ceramic medium layer, and the outer electrode is disposed at least on a first surface of the ceramic body, wherein
the first surface is a side surface of the ceramic body facing the circuit board.

3. The MLCC capacitor according to claim 2, wherein the inner electrode comprises a main body segment and a connection segment that are connected to each other, the main body segment extends in the first direction, the connection segment is inclined to the main body segment, and the connection segment extends to an outer surface of the ceramic body and is connected to the outer electrode.

4. The MLCC capacitor according to claim 3, wherein the connection segment comprises a first segment and a second segment, a head end of the first segment and a head end of the second segment are both connected to the main body segment, a tail end of the first segment extends to the first surface, a tail end of the second segment extends to a second surface of the ceramic body, and both the first surface and the second surface are provided with the outer electrode, wherein
the second surface is a side surface of the ceramic body opposite to the first surface.

5. The MLCC capacitor according to claim 4, wherein the first segment and the second segment are both perpendicular to the main body segment.

6. The MLCC capacitor according to claim 4, wherein the first segment obliquely extends to an edge of a corresponding side of the ceramic medium layer from the head end of the first segment to the tail end of the first segment; and
the second segment obliquely extends to an edge of a corresponding side of the ceramic medium layer from the head end of the second segment to the tail end of the second segment.

7. The MLCC capacitor according to claim 6, wherein an included angle between the first segment and the main body segment is the same as an included angle between the second segment and the main body segment.

8. The MLCC capacitor according to claim 3, wherein a head end of the connection segment is connected to the main body segment, a tail end of the connection segment extends to the first surface, and the first surface is provided with the outer electrode.

9. The MLCC capacitor according to claim 8, wherein the connection segment is perpendicular to the main body segment; or
the connection segment inclines to an edge of a corresponding side of the ceramic medium layer from the head end of the connection segment to the tail end of the connection segment.

10. The MLCC capacitor according to any one of claims 3 to 9, wherein the connection segment is connected to an end of the main body segment.

11. The MLCC capacitor according to any one of claims 3 to 10, wherein in a direction perpendicular to the board surface of the circuit board, the main body segment is located in a central region of the ceramic medium layer.

12. The MLCC capacitor according to any one of claims 3 to 11, wherein in a stacking direction of the inner electrodes, the connection segment close to a first side of the ceramic body and the connection segment close to a second side of the ceramic body are alternately disposed, wherein the first side and the second side are respectively opposite sides of the ceramic body in the first direction; and
the outer electrode comprises a first electrode and a second electrode, the first electrode is connected to the connection segment close to the first side of the ceramic body, and the second electrode is connected to the connection segment close to the second side of the ceramic body.

13. A method for manufacturing an MLCC capacitor, applied to manufacture the MLCC capacitor according to any one of claims 1 to 12, wherein the manufacturing method comprises:
printing an inner electrode on a ceramic medium layer;
sequentially stacking a plurality of ceramic medium layers to form a stack;
segmenting the stack, for a cut surface to expose a plurality of inner electrodes that are staggered at intervals in a stacking direction of the ceramic medium layers, to form a plurality of ceramic bodies; and
forming an outer electrode on an outer surface of the ceramic body, wherein the outer electrode is connected to each inner electrode.

14. The method for manufacturing an MLCC capacitor according to claim 13, wherein the sequentially stacking a plurality of ceramic medium layers comprises:
aligning edges of the ceramic medium layers.

15. The method for manufacturing an MLCC capacitor according to claim 14, wherein the inner electrode comprises a main body segment and a connection segment that are connected to each other, the main body segment extends in a first direction parallel to a circuit board, and the connection segment is inclined to the main body segment; and
the sequentially stacking a plurality of ceramic medium layers comprises:
in a stacking direction of the ceramic medium layers, alternately disposing the connection segment close to a first side of the ceramic body and the connection segment close to a second side of the ceramic body, wherein the first side and the second side are respectively two opposite sides of the ceramic body in the first direction.

16. The method for manufacturing an MLCC capacitor according to claim 15, wherein the connection segment comprises a first segment and a second segment, a head end of the first segment and a head end of the second segment are both connected to the main body segment, and a tail end of the first segment and a tail end of the second segment respectively extend toward two sides of the main body segment; and
the sequentially stacking a plurality of ceramic medium layers comprises:
rotating one of two adjacent ceramic medium layers by 180° in the stacking direction of the ceramic medium layers, and reversely stacking the one of the two adjacent ceramic medium layers and the other ceramic medium layer.

17. The method for manufacturing an MLCC capacitor according to claim 15, wherein a head end of the connection segment is connected to the main body segment, and a tail end of the connection segment extends to a side of the main body segment; and
the sequentially stacking a plurality of ceramic medium layers comprises:
forming a first ceramic medium layer, wherein the connection segment on the first ceramic medium layer is close to the first side of the ceramic body;
forming a second ceramic medium layer, wherein the connection segment on the second ceramic medium layer is close to the second side of the ceramic body; and
alternately stacking the first ceramic layer and the second ceramic medium layer.

18. The method for manufacturing an MLCC capacitor according to any one of claims 15 to 17, wherein the forming an outer electrode comprises:
forming a first electrode and a second electrode, wherein the first electrode is connected to the connection segment close to the first side of the ceramic body, and the second electrode is connected to the connection segment close to the second side of the ceramic body.

19. A circuit board assembly, comprising a circuit board and the MLCC capacitor according to any one of claims 1 to 12, wherein
the MLCC capacitor is mounted on the circuit board, and each ceramic medium layer and each inner electrode of the MLCC capacitor are perpendicular to a board surface of the circuit board.

20. An electronic device, comprising a housing and the circuit board assembly according to claim 19, wherein the circuit board assembly is disposed in the housing.
